# EUROPEAN PATENT APPLICATION

(11) **EP 4 572 553 A1**
(43) Date of publication of application: **18.06.2025**
(21) Application number: 24218888.6
(22) Date of filing: 10.12.2024
(51) Int. Cl.: H05K 7/20

(54) **AN INTEGRATED, PUMPED, CLOSED-LOOP TWO-PHASE HEATSINK BACKGROUND**

(30) Priority: 11.12.2023 US 202318535353
(71) Applicant: Google LLC, Mountain View, CA 94043 (US)
(72) Inventor: LIU, Tanya, Mountain View, 94043 (US); IYENGAR, Madhusudan K., Mountain View, 94043 (US)
(74) Representative: Betten & Resch

(57) **Abstract**

A heatsink cooling system includes a liquid reservoir; a boiling chamber configured to boil a liquid when heated from an external heat source adjacent the boiling chamber; a pump in fluid communication with the liquid reservoir and the boiling chamber; and a vapor space in fluid communication with the liquid reservoir separated from the boiling chamber by a membrane, wherein vapor evaporated from the boiling chamber is configured to pass through the membrane into the vapor space, condense into a liquid within the vapor space, and return to the liquid reservoir.

## Description

### BACKGROUND

Conventional data centers include racks of electrical components that are spaced apart from each other to form aisles. Such racks include heat-generating electrical components like chips, hard drives, power supplies, etc. If enough heat is generated, the electrical components can be damaged if the heat is not properly dissipated away from the rack.

Typically, data centers are cooled using air-cooling methods and systems. Many data centers use large fans that distribute air down the aisles between the racks such that the air can absorb the heat generated from the electrical components. Such air-cooling methods are not without drawbacks. Because of the rack and aisle arrangement of data centers, electrical components closer to the fans or blowers will be cooled more efficiently than electrical components positioned further away from the fans or blowers because the cooling air at the further electrical component has already absorbed the heat from the closer electrical component. Likewise, data centers implementing air-cooling require special ventilation systems that remove the warm air from the data center and replace it with cooler, conditioned air.

Due to the drawbacks of air-cooling, some data centers implement liquid cooling in conjunction with air cooling to cool individual electrical components on a rack. Liquid cooling often manages higher heat fluxes better than air cooling, but also has drawbacks. Liquid cooling systems require pumps or other devices to pressurize the liquid and move it throughout the system. Such pumps may be bulky and difficult to position on or near a data center rack. Like air cooling, as the liquid coolant is heated after absorbing heat from an electrical component, the liquid is less efficient at cooling downstream electrical components. Thus, the coolant often needs to be replaced and cannot be recycled.

### BRIEF SUMMARY

A heatsink cooling system can be used to cool various electrical components within a data center. Such a heatsink includes a boiling chamber, a liquid reservoir, and a vapor space positioned above the boiling chamber. The heatsink is mounted to an electrical component, and heat from the electrical component heats and ultimately boils liquid within the boiling chamber. As the liquid vaporizes, it passes through a membrane into the vapor space. While in the vapor space, the vapor condenses and flows to the liquid reservoir, where it is then pumped back into the boiling chamber. Such a cooling liquid may absorb the heat from the electrical component and distribute the heat away from the component.

According to one aspect of the present disclosure, a heatsink cooling system comprises a liquid reservoir; a boiling chamber configured to boil a liquid when heated from an external heat source adjacent the boiling chamber; a pump in fluid communication with the liquid reservoir and the boiling chamber; and a vapor space in fluid communication with the liquid reservoir separated from the boiling chamber by a membrane, wherein vapor evaporated from the boiling chamber is configured to pass through the membrane into the vapor space, condense into a liquid within the vapor space, and return to the liquid reservoir.

In some examples, the pump is configured to supply liquid from the liquid reservoir to the boiling chamber.

In some examples, the pump is housed within a body of the heatsink.

In some examples, the pump is positioned outside the body of the heatsink.

In some examples, the system further comprises a pressure sensor positioned within the boiling chamber.

In some examples, the system further comprises a controller configured to communicate with the pump to adjust a volumetric flow rate and a pressure of the liquid being supplied to the boiling chamber.

In some examples, the system further comprises an external heating system configured to heat the membrane.

In some examples, the system further comprises a valve positioned between the liquid reservoir and the boiling chamber, such that opening and closing of the valve regulates a fluid pressure within the boiling chamber.

In some examples, the system further comprises a check valve between the liquid reservoir and the vapor space, the check valve configured to prevent liquid from passing from the liquid reservoir to the vapor space.

In some examples, the boiling chamber, the vapor space, and the liquid reservoir form a closed loop.

In some examples, the system further comprises a condensate trap positioned within the vapor space, the condensate trap configured to direct condensed liquid within the vapor space to the liquid reservoir.

In some examples, the heatsink is mountable to the external heat source such that a portion of the heatsink body surrounding the boiling chamber contacts the external heat source at a position directly above the external heat source.

According to another aspect of the present disclosure, a heatsink cooling system comprises a liquid reservoir in fluid communication with a boiling chamber; a vapor space separated from the boiling chamber by a membrane; and a pumping system configured to supply liquid from the liquid reservoir to the boiling chamber, such that upon the boiling chamber being heated by an external heat source, vapor passes through the membrane into the vapor space, condenses, and returns to the liquid reservoir to form a closed loop.

In some examples, the system further comprises a condenser region positioned adjacent the vapor space.

In some examples, the condenser region includes a plurality of fins.

In some examples, the pumping system includes a piston-driven pump.

In some examples, the reservoir and pump are positioned outside a body of the heatsink and are fluidly connected with the boiling chamber and vapor space.

In some examples, the system further comprises an external reservoir fluidly connected to the liquid reservoir.

According to another aspect of the present disclosure, a method of cooling a chip using a heatsink cooling system comprises positioning a boiling chamber of the heatsink adjacent the chip such that the chip heats the boiling chamber; modulating a valve to supply a liquid from a reservoir to the boiling chamber such that the liquid boils and evaporates through a membrane separating the boiling chamber from a vapor space; and directing condensed vapor from the vapor space to the reservoir to form a closed loop.

In some examples, the directing includes catching liquid in a condensate trap and directing the liquid to the reservoir.

In some examples, the method further comprises supplying a liquid to the reservoir from an external reservoir positioned within a rack of a data center.

### BRIEF DESCRIPTION OF THE DRAWINGS

FIG. 1A is a side view of a first heatsink according to aspects of the disclosure.
FIG. 1B is a side view of another example implementation of the first heatsink of FIG. 1A.
FIG. 2 is a side view of a second heatsink according to aspects of the disclosure.
FIG. 3 is a side view of a third heatsink according to aspects of the disclosure.
FIG. 4A is a side view of a fourth heatsink according to aspects of the disclosure.
FIG. 4B is a top view of the fourth heatsink of FIG. 4A.
FIG. 5 is a side view of a fifth heatsink according to aspects of the disclosure.
FIG. 6A is a side view of a sixth heatsink according to aspects of the disclosure.
FIG. 6B is another side view of the sixth heatsink of FIG. 6A.
FIG. 7A is a side view of a seventh heatsink according to aspects of the disclosure.
FIG. 7B is another side view of the seventh heatsink of FIG. 7A.
FIG. 7C is a side view of an alternative implementation of the seventh heatsink of FIG. 7A.
FIG. 8 is a side view of an eight heatsink according to aspects of the disclosure.
FIG. 9 is a flow chart illustrating a method of cooling a chip using the heatsink cooling system of FIG. 1A.

### DETAILED DESCRIPTION

Reference will now be made in detail to the various implementations of the present disclosure illustrated in the accompanying drawings. It should be noted that the drawings are in simplified form and are not drawn to precise scale. Additionally, the term "a," as used in the specification, means "at least one." The terminology includes the words above specifically mentioned, derivatives thereof, and words of similar import. Although at least two variations are described herein, other variations may include aspects described herein combined in any suitable manner having combinations of all or some of the aspects described.

The cooling system and methods described herein may be broadly implemented with a plurality of heat-producing devices. In some examples, the cooling system and methods may be implemented with computer chips within data centers. The chip may be a central processing unit (CPU), graphics processing unit (GPU), application-specific integrated circuit (ASIC), tensor processing unit (TPU), and the like. Although such chips are described herein, it is foreseeable that the disclosed cooling systems and methods may be implemented with other heat-producing devices, such as hard drives, personal computers, video game consoles, and the like.

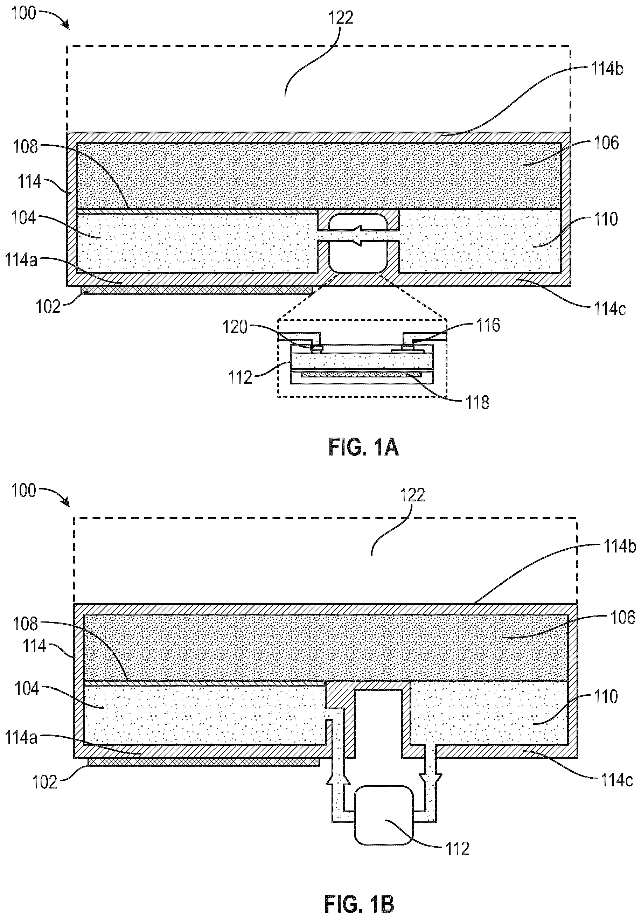

FIGS. 1A and 1B broadly illustrate a first cooling system 100, which acts as a heatsink in some examples for cooling a heat-producing device, such as a chip 102. Cooling system 100 includes a boiling chamber 104, a vapor space 106 separated from boiling chamber 104 by a membrane 108, and a liquid reservoir 110 in fluid communication with boiling chamber 104. A pump 112 is configured to draw liquid from the liquid reservoir 110 and supply the liquid to boiling chamber 104. A heatsink body 114 surrounds each of boiling chamber 104, vapor space 106, and liquid reservoir 110 to form cooling system 100. As such, heatsink body 114 includes a heatsink body 114a at least partially surrounding boiling chamber 104, a heatsink body 114b at least partially surrounding vapor space 106, and a heatsink body 114c at least partially surrounding liquid reservoir 110.

Continuing with the example of FIGS. 1A and 1B, heatsink body 114a may be mounted to chip 102 such that boiling chamber 104 is positioned above chip 102. Such a mounting may be facilitated by directly contacting heatsink body 114a with chip 102, or placing heatsink body 114a near chip 102 such that heat can transfer from chip 102 to heatsink body 114a. Thermal paste, thermal pads, phase change material, solder, or the like may be applied to such chips 102 to facilitate the heat transfer from chip 102 to heatsink body 114a. Heatsink body 114a may include fins, sintered powder, micropillars, microchannels, and/or inverse opals to enhance the heat transfer coefficient of the boiling liquid within boiling chamber 104.

Boiling chamber 104 is configured to contain and be at least partially filled with a liquid received from liquid reservoir 110. Such a liquid may be water, a solution containing both water and refrigerants like propylene glycol or ethylene glycol, or refrigerants. In use, heat conductively transfers through heatsink body 114a to the liquid within boiling chamber 104. Due to heat supplied by chip 102, the liquid boils and changes phase from a liquid to a vapor. The vapor then passes through membrane 108 and moves into the vapor space 106. The pressure within boiling chamber 104 caused by pump 112 increases the maximum heat flux limit of cooling system 100 over standard vapor chamber style heatsinks by removing vapor bubbles at a higher rate from the boiling surface, delaying the onset of dryout and formation of a high thermal resistance vapor film. A closed loop is formed between boiling chamber 104, vapor space 106, and liquid reservoir 110, such that the same coolant may be continuously used for cooling a particular chip without needing to supply external coolant to the heatsink. Such a closed loop cooling system is considered a "two-phase" cooling system as the coolant is a liquid within boiling chamber 104, vaporizes into a vapor and passes into vapor space 106, and then condenses back into a liquid before being supplied to liquid reservoir 110.

Membrane 108 is a hydrophobic membrane that allows vapor to pass through pores formed within membrane 108. Membrane 108 is removable from an upper perimeter of boiling chamber 104 to allow for easier serviceability and replacement of membrane 108. Membrane 108 may be sealed to boiling chamber 104 by releasable sealing methods such as gaskets, O-rings, and the like, or it may be permanently sealed using adhesives such as epoxy, silicone caulk, and the like. Additionally, if membrane 108 includes a metal that contacts heatsink body 114, soldering, electroplating, and other metal-metal bonding methods may be implemented. Many materials may be used to form membrane 108, such as polymers like Polytetrafluoroethylene (PTFE), polypropylene (PP), and polycarbonate (PC). Alternatively, membrane 108 may be ceramic or metal that has been treated with a hydrophobic coating.

Pump 112 is configured to move liquid from liquid reservoir 110 to boiling chamber 104, which in turn pressurizes boiling chamber 104 and increases the fluid head within boiling chamber 104. Pump 112 may take many forms. In some implementations, such as the implementation illustrated in FIG. 1A, pump 112 may be integrated within the heatsink body 114. In other implementations, such as the implementation illustrated in FIG. 1B, pump 112 may be an external pump connected to the heatsink by a plurality of pipes, tubing, and/or fluid connectors. Regardless of the pump's position relative to the heatsink, pump 112 may be a piezoelectric pump, a centrifugal pump, or other similar pump types. As illustrated in FIGS. 1A and 1B, pump 112 is a piezoelectric pump including an inlet valve 116, an actuator 118, and an outlet valve 120. A controller is configured to modulate each of the actuator 118 and associated valves 116, 120 to control the volumetric flow rate and pressure of liquid being supplied to boiling chamber 104.

Heatsink body 114 includes various heat transfer elements configured to direct heat away from chip 102. In some implementations, a portion of the heatsink body between heatsink body 114a and 114c includes cutouts or insulation to prevent the liquid within the reservoir from boiling/evaporating. Heatsink body 114c may further define a condenser portion 122 positioned above vapor space 106. Condenser portion 122 includes fins, micropillars, or other structures that increase the surface area heatsink body 114b and enhance the heat transfer coefficient between the heatsink body 114 and surrounding air. Condenser portion 122 may also be cooled by a refrigerant loop (not shown) that circulates throughout condenser portion 122. Such a condenser portion 122 may include a wick or it may be wickless. In implementations with a wick, the wick is elongated such that it extends across the entire length of condenser portion 122, which in turn extends across the entire length of heatsink body 114. Further, the wick may be thicker along a portion of its length that is above boiling chamber 104 to help prevent excess condensate from falling back onto membrane 108 due to gravity. As such, the wick may be thinner along a portion of its length that is above liquid reservoir 110. Condenser portion 122 may extend along the entire length of heatsink body 114, as described above, or it may extend along only a portion of the length of heatsink body 114. If condenser portion 122 extends along only a portion of the length of the heatsink body 114, it may be positioned above boiling chamber 104 to enable two-dimensional heat spreading away from the vapor space 106.

Vapor space 106 is a generally hollow chamber that extends along the entire length of heatsink body 114 such that vapor may enter vapor space 106 above boiling chamber 104, condense into liquid within vapor space 106, and then such a liquid may be supplied to liquid reservoir 110. As such, vapor space 106 has a length longer than the lengths of both boiling chamber 104 and liquid reservoir 110.

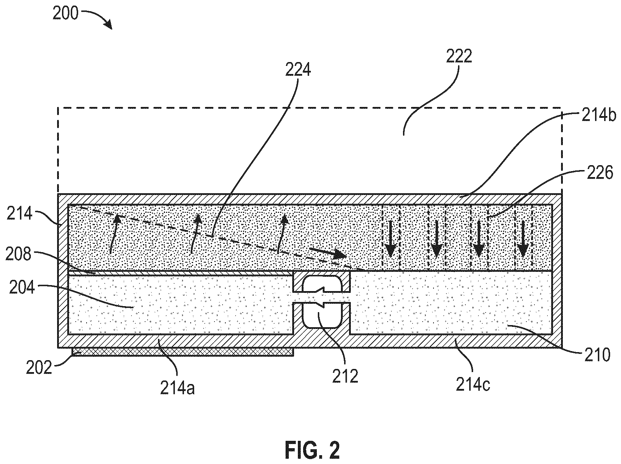

FIG. 2 illustrates another implementation of a heatsink cooling system. In this implementation, cooling system 200 is similar to cooling system 100, and thus the differences will be described herein. Cooling system 200 includes a heatsink body 214 encapsulating a boiling chamber 204, vapor space 206, and a liquid reservoir 210. A membrane 208 separates vapor space 206 from boiling chamber 204. A pump 212 is integrated within heatsink body 214 and is positioned between boiling chamber 204 and liquid reservoir 210.

Cooling system 200 further includes a condensate trap 224 extending at least partially through vapor space 206 above boiling chamber 204. Condensate trap 224 is elongated and extends from a perimeter of heatsink body 214b to liquid reservoir 210. Such a trap is configured to divert stray condensate within vapor space 206 back to liquid reservoir 201 such that the condensate doesn't drip onto membrane 208, which could clog pores of membrane 208 and inhibit heat transfer away from chip 202. Condensate trap 224 may take many forms, including conical, pyramidal, or other types of sloped mesh that allow vapor to pass therethrough. Such mesh could be hydrophobic for rapid droplet removal and for encouraging droplets to slide down into liquid reservoir 210. The mesh could also be superhydrophobic to enable jumping droplet condensate removal. In implementations that don't utilize mesh, a perforated plate with periodic grooves for condensate to travel along a wick towards liquid reservoir 210 may be utilized. Additionally, guides or structures 226 may be positioned within vapor space 206 above liquid reservoir 210. Such structures 226 may be mesh columns, wire bundles, porous posts, or the like, and are configured to drive condensate return from vapor space 206 located above the surface of liquid reservoir 210.

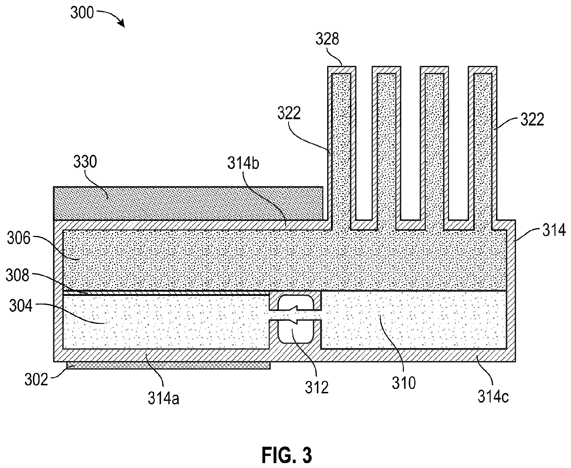

FIG. 3 illustrates another implementation of a heatsink cooling system. In this implementation, cooling system 300 is similar to cooling system 100, and thus the differences will be described herein. Cooling system 200 includes a heatsink body 314 encapsulating a boiling chamber 304, vapor space 306, and a liquid reservoir 310. A membrane 308 separates vapor space 306 from boiling chamber 304. A pump 312 is integrated within heatsink body 314 and is positioned between boiling chamber 304 and liquid reservoir 310.

Cooling system 300 further includes a condenser portion 322 positioned above vapor space 306. Condenser portion 322 includes integrated heat pipes 328 configured to facilitate additional heat transfer away from the heatsink body 314. Integrated heat pipes 328 may be concentrated in a region of condenser portion 322 above liquid reservoir 310 or may span the entire length of the heatsink body 314. If heat pipes 328 are concentrated above liquid reservoir 310, then an insulation layer 330 may be formed in a region of condenser portion 322 above boiling chamber 304 to facilitate condensate formation above liquid reservoir 310 and to minimize potential clogging of membrane 308 when condensate drips from heatsink body 314b to membrane 308.

Heat pipes 328 may include additional heat transfer elements such as fins, micropillars, or other extended surfaces that increase the surface area of the heat pipe and facilitate additional heat transfer. Further, heat pipes 328 may include wicks, depending on the particular implementation and whether it is desired to have a gravitational return of condensate to the liquid reservoir. The implementation of heat pipes 328 with wicks may further depend upon the position of heat pipes 328, which may be positioned such that they extend upward away from heatsink body 314b or laterally off a side portion of heatsink body 314.

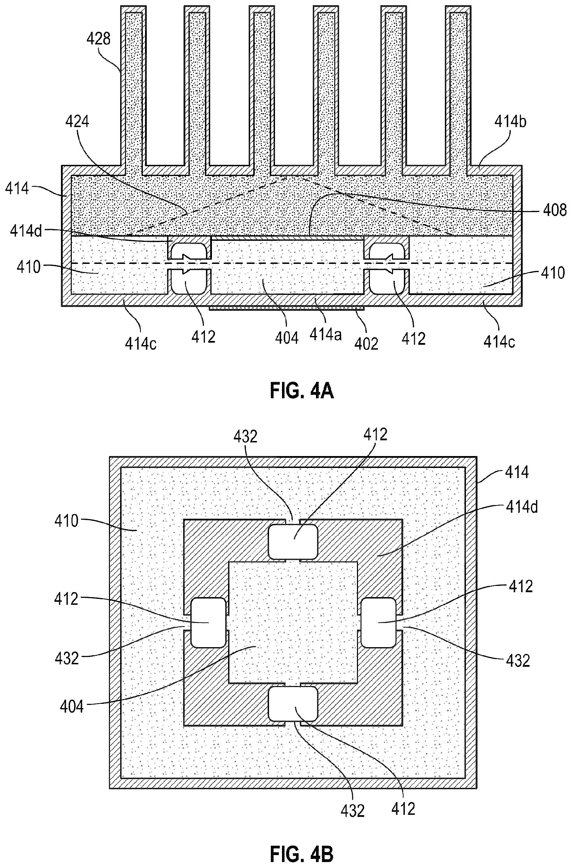

FIGS. 4A and 4B illustrate another implementation of a heatsink cooling system. In this implementation, cooling system 400 is similar to cooling system 100, and thus the differences will be described herein. Cooling system 400 includes a heatsink body 414 encapsulating a boiling chamber 404, vapor space 406, and a liquid reservoir 410. A membrane 408 separates vapor space 406 from boiling chamber 404. Pumps 412 are integrated within heatsink body 414 and are positioned between boiling chamber 404 and liquid reservoir 410.

Unlike the previous implementations, boiling chamber 404 is centrally located within heatsink body 414. As such, a plurality of individual liquid reservoirs or a larger continuous liquid reservoir 410 is positioned around the perimeter of boiling chamber 404. FIG. 4B illustrates various channels 432 formed in the heatsink body 414 surrounding the centralized boiling chamber 404. Each channel 432 may include a pump 412 configured to draw liquid from liquid reservoir 410 and supply that liquid to boiling chamber 404. Heatsink 400 may be substantially square-shaped and may include a channel 432 and pump 412 at each internal heatsink body portion 414d to form a square perimeter around the centralized boiling chamber 404. In alternative implementations, the heatsink may be circular and have circular boiling chambers and reservoirs. In such a circular implementation, the channels and pumps may be positioned at regular intervals around the perimeter of the circular heatsink body surrounding the boiling chamber. In other examples, the perimeter may have other shapes, such as rectangular or irregular shapes, and various channels and pumps may be positioned at various intervals around the perimeters of such shapes to allow for a consistent influx of liquid to the liquid reservoir. Particularly, the channels and pumps may be positioned such that each pump is supplying a similar volumetric flow rate of liquid to the boiling chamber.

Continuing with the fourth implementation illustrated in FIG. 4A, heatsink 400 may include a condensate trap 424 positioned within vapor space 406 and configured to catch stray condensate and return it to liquid reservoir 410. Such a condensate trap 424 may be conical, pyramidal, or otherwise structured so that a highest point of the trap is positioned over boiling chamber 404 to direct stray condensate to liquid reservoir 410 rather than to membrane 408. Additionally, heat pipes 428 may be integrally formed with the heatsink body 414b above the vapor space to facilitate further heat transfer away from the heatsink 400.

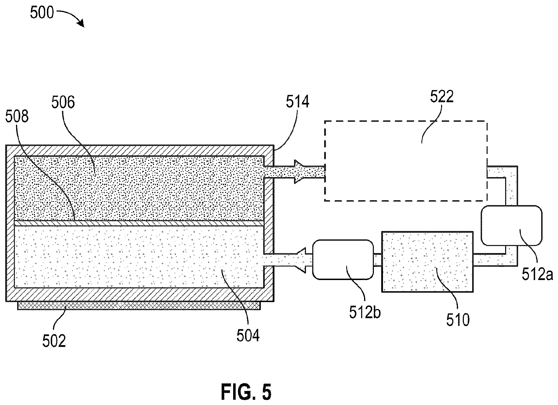

FIG. 5 illustrates another implementation of a heatsink cooling system. In this implementation, cooling system 500 is similar to cooling system 100, and thus the differences will be described herein. Cooling system 500 includes a heatsink body 514 encapsulating a boiling chamber 504 and a vapor space 506. A membrane 508 separates vapor space 506 from boiling chamber 504.

Unlike the previous implementations, a liquid reservoir 510 is not positioned internally within heatsink body 514, but rather is positioned outside of heatsink body 514 and is capable of feeding a plurality of heatsink bodies, although a single heatsink body 514 is illustrated in FIG. 5 for simplicity. As such, the reservoir may include various fluid connectors such as tubing and pipes to create a flow path for the liquid flowing through reservoir 510. An external condenser 522 may also be positioned within the flow path of the cooling liquid to release heat away from the heatsink 500. As illustrated in FIG. 5, condenser 522 is positioned downstream of vapor space 506, but upstream of liquid reservoir 510. Various pumps 512a, 512b may be positioned within the flow path of the cooling liquid. For example, a first pump 512a may be positioned between condenser 522 and the reservoir 510, and a second pump 512b may be positioned between reservoir 510 and the boiling chamber 504, and each pump may be operated in a separate control loop. The first pump 512a is configured to control the liquid supply and pressure of liquid supplied to reservoir 510 and the second pump 512b is configured to control the liquid supply and pressure of liquid supplied to boiling chamber 504 . Alternatively, a single pump may control the fluid flow characteristics depending on the desired pressure and volume of liquid flowing within the path. Various pressure sensors and liquid level sensors may be placed throughout boiling chamber 504 and reservoir 510 to monitor various conditions of the liquid therein.

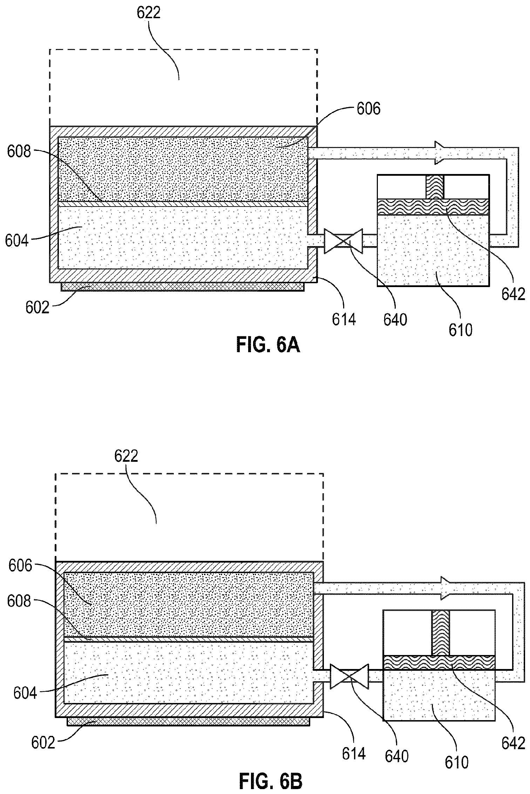

FIGS. 6A and 6B illustrate another implementation of a heatsink cooling system. In this implementation, cooling system 600 is similar to cooling system 100, and thus the differences will be described herein. Cooling system 600 includes a heatsink body 614 encapsulating a boiling chamber 604 and a vapor space 606. A membrane 608 separates vapor space 606 from boiling chamber 604. Although an external liquid reservoir 610 is illustrated in both FIG. 6A and 6B, it is appreciated that liquid reservoir 610 may be integrated within heatsink body 614. Likewise, although condenser portion 622 is shown mounted on heatsink body 614, condenser portion 622 may also be positioned outside of heatsink body 614.

Cooling system 600 includes a valve 640 positioned between liquid reservoir 610 and boiling chamber 604. Valve 640 is configured to control the volumetric flow rate of the liquid being supplied to boiling chamber 604 from reservoir 610. As such, a pump is not needed, and rather a simpler device, such as a hydraulic piston 642, may be used to supply liquid to the boiling chamber 604. In use, piston 642 can be modulated along with valve 640 to supply a desired volume and pressure of liquid to boiling chamber 604. For example, a desired volumetric flow rate may be between 0-50 mL/min, and a desired pressure may be between 0 - 100 kPa. Such a modulation can be controlled with a controller that receives inputs from various sensors positioned throughout cooling system 600. Such a controller may raise/lower piston 642 in conjunction with opening/closing valve 640 to control the pressure and flow rate of liquid being supplied to boiling chamber 604. In one example illustrated in FIG. 6A, piston 642 is raised and valve 640 is closed, which yields low pressure within boiling chamber 604. In another example illustrated in FIG. 6B, piston 642 is lowered and valve 610 is opened, which yields a higher pressure within boiling chamber 604. It is appreciated that piston 642 and valve 640 can both be modulated to a variety of positions to control the supply of liquid.

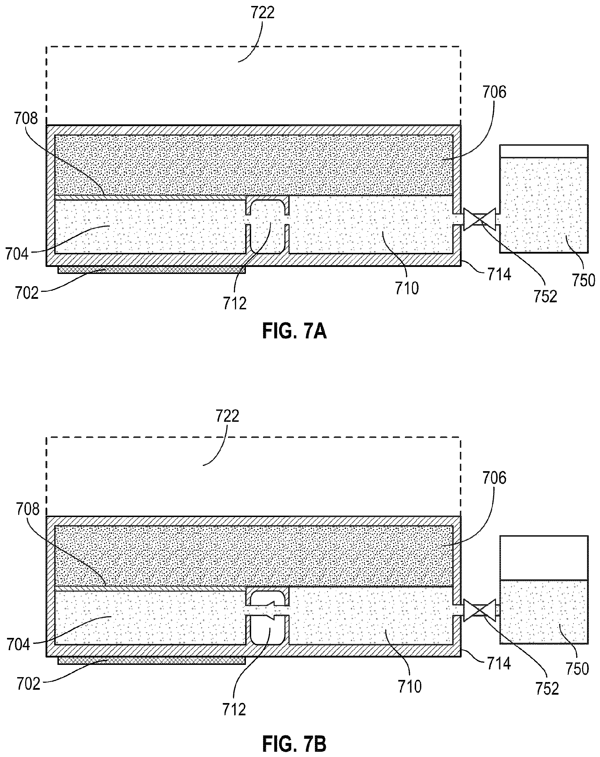

FIGS. 7A - 7C illustrate another implementation of a heatsink cooling system. In this implementation, cooling system 700 is similar to cooling system 100, and thus the differences will be described herein. Cooling system 700 includes a heatsink body 714 encapsulating a boiling chamber 704, vapor space 706, and a liquid reservoir 710. A membrane 708 separates vapor space 706 from boiling chamber 704. Pumps 712 are integrated within heatsink body 714 and are positioned between boiling chamber 704 and liquid reservoir 710.

An external reservoir 750 is provided in fluid communication with liquid reservoir 710. Such an external reservoir 750 is desired for situations in which heatsink 700 is transported or otherwise oriented such that the liquid within liquid reservoir 710 may spill into vapor space 706, thereby potentially damaging membrane 708. An external reservoir 750 allows the cooling system 700 to be transported without any cooling liquid therein, as is illustrated in FIG. 7A, and then filled or "charged" once the cooling system arrives at its destination, as is illustrated in FIG. 7B. External reservoir 750 may include a pump or other pressurization system to cause liquid to flow from external reservoir 750 to liquid reservoir 710. Further, a valve 752 is positioned within a sidewall portion of heatsink body 714 adjacent liquid reservoir 710 such that external reservoir 750 can be fluidly and removably connected with liquid reservoir 710. Various pipes, tubing, and/or fluid connectors may be implemented to connect external reservoir 750 with liquid reservoir 710.

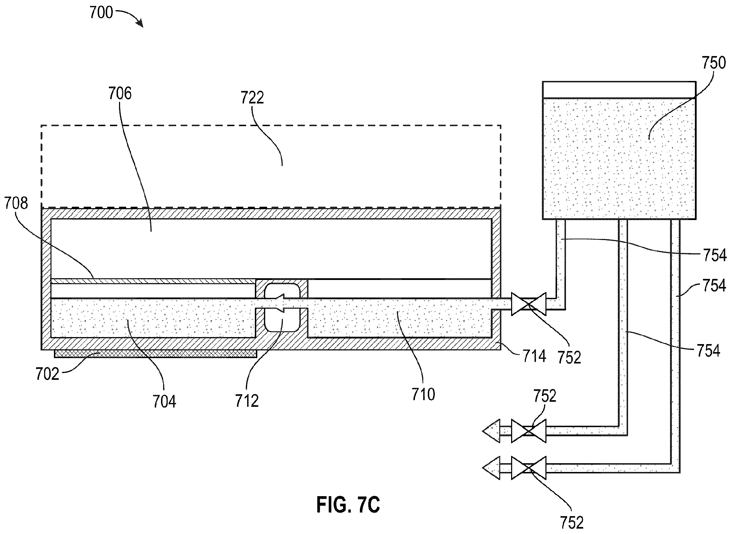

FIG. 7C illustrates external reservoir 750 that has multiple branches 754. Such an external reservoir 750 is advantageous for data center cooling systems, such as by saving space. For example, reservoir 750 may be mounted to the racks and/or trays of the data centers, and the large volume of reservoir 750 may then supply coolant to each of the individual heatsinks implemented within the data center. Once the individual reservoirs 710 within the data center have been sufficiently filled, external reservoir 750 can be disconnected from liquid reservoir 710 for space savings and weight savings within the structure of the data center.

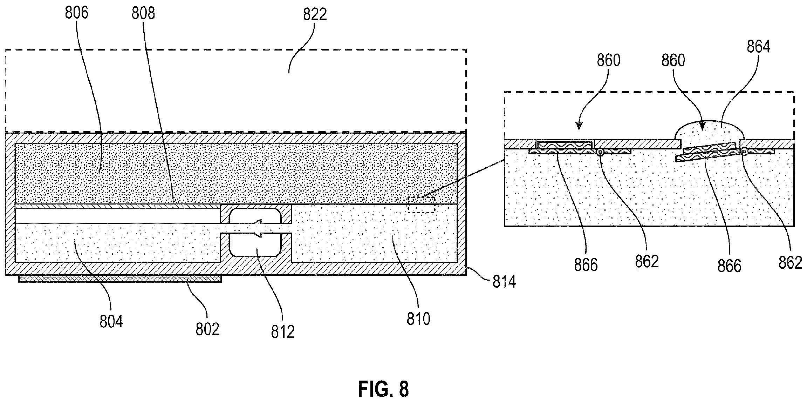

FIG. 8 illustrates another implementation of a heatsink cooling system. In this implementation, cooling system 800 is similar to cooling system 100, and thus the differences will be described herein. Cooling system 800 includes a heatsink body 814 encapsulating a boiling chamber 804, vapor space 806, and a liquid reservoir 810. A membrane 808 separates vapor space 806 from boiling chamber 804. A pump 812 is integrated within heatsink body 814 and is positioned between boiling chamber 804 and liquid reservoir 810.

Cooling system 800 further includes a one-way valve 860 positioned in heatsink body 814 between the vapor space 806 and the liquid reservoir 810. One-way valve 860 is configured to prevent liquid from spilling out of liquid reservoir 810 into the vapor space 806, while also allowing condensate to enter liquid reservoir 810 from vapor space 806.

One way valve 810 may include check valves, ball valves, and the like to ensure that liquid cannot pass from liquid reservoir 810 to vapor space 806 above the liquid reservoir 810. One-way valve 860 may be attached to heatsink body 814 via hinges 862 that allow a flap 866 to open when the weight of the falling droplet 864 of condensate presses the valve downward. Additionally, if the heatsink were to be flipped upside down during transportation, the hinged valve design would prevent liquid from the liquid reservoir from entering the vapor space. Such a one-way valve design may also be incorporated with the return structures 226 implemented with the second cooling system 200. As such, the return structures may span the height of vapor space 806 and may be sealed to the one-way valve 860 at one end to cause liquid from the return structure to enter liquid reservoir 810. Such a structure also acts as a one-way liquid diode and works in conjunction with the one-way valves to ensure that liquid passes from vapor space 806 to the liquid reservoir 810, and not from liquid reservoir 810 into the vapor space 806.

It is appreciated that the various implementations disclosed herein may be modular and modifiable with components of other cooling systems. For example, a condensate trap, similar to condensate trap 224, may be added to cooling system 700. Likewise, piston 642 of cooling system 600 may be swapped with a pump 212 of cooling system 200. Furthermore, any of the membranes disclosed herein, such as membrane 108, may be attached to a heating system configured to heat the membrane such that any liquid on the membrane evaporates away from the membrane, thereby preventing the membrane from clogging or prematurely degrading. In such examples, the membrane may be made from a conductive material, such as gold or aluminum, or it may be made from various polymers, ceramics, or the like and have a conductive coating applied to its surface, e.g., a gold coating applied to a porous ceramic membrane. Such a membrane may further include electrical contacts that enable the membrane to connect to a printed circuit board positioned outside of the heatsink. Various heating methods may be utilized to heat the membrane, e.g., Joule heating. The membrane may be heated a single time after the heatsink has been installed and the liquid reservoir has been filled, or it may be heated at periodic intervals throughout the lifespan of the heatsink.

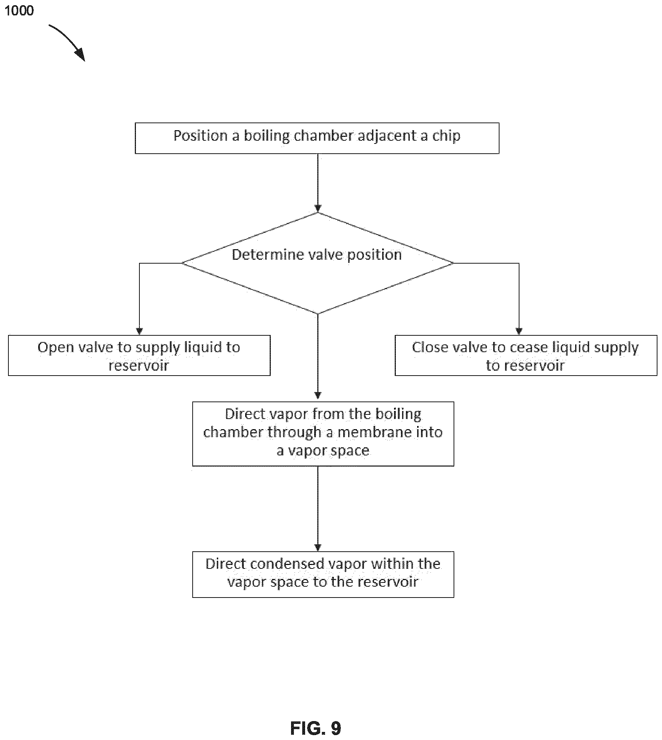

A method 1000 of attaching a heatsink cooling system to a chip or other heat-producing electronic device is disclosed herein and is illustrated in FIG. 9. For sake of brevity, only a method of attaching heatsink cooling system 100 to a chip 102 is described in detail, although it is appreciated that similar methods can be implemented for the other cooling systems disclosed herein.

An operator and/or automated device may first manipulate cooling system 100 such that a portion of heatsink body 114a is adjacent chip 102. Thermal paste or the like may be applied to chip 102, and then heatsink body 114a may be pressed onto chip 102 and may be further retained with various retaining systems. If cooling system 100 was attached without a cooling liquid present in liquid reservoir 100, an external reservoir, such as reservoir 750, may be attached to liquid reservoir 100 to supply liquid to liquid reservoir 100. A user may power cooling device 100 via battery, outlets, or other power methods, and may activate a controller of cooling system 100, which in turn activates pump 112 to draw liquid from liquid reservoir 110 to boiling chamber 104.

In use, as chip 102 heats up, liquid within boiling chamber 104 boils and vaporizes, and such vapor passes through membrane 108 into vapor space 106. The vapor may cool within vapor space 106 and heat may further be dissipated away from heatsink body 114b by transferring through condenser region 122. As the vapor cools, it condenses back into liquid and falls into liquid reservoir 112, where it can then be reused to cool chip 102.

The cooling systems disclosed herein are particularly advantageous over conventional cooling systems. Liquid cooling is advantageous over air cooling as the structure of data centers often inhibits cold air from reaching all of the heat-producing components within data centers. Liquid cooling allows particular components to be cooled regardless of their orientation within the data center relative to the fans or blowers. Further, the cooling systems disclosed herein are particularly advantageous as they are closed-loop systems. As such, the cooling systems may operate as independent systems without the need to continuously supply new cooling liquid to the systems or to remove cooling liquid from the systems. As such, the cooling systems disclosed herein have a smaller footprint and increased cost-savings over conventional cooling systems.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

## Claims

1. A heatsink cooling system comprising:
a liquid reservoir;
a boiling chamber configured to boil a liquid when heated from an external heat source adjacent the boiling chamber;
a pump in fluid communication with the liquid reservoir and the boiling chamber; and
a vapor space in fluid communication with the liquid reservoir separated from the boiling chamber by a membrane, wherein vapor evaporated from the boiling chamber is configured to pass through the membrane into the vapor space, condense into a liquid within the vapor space, and return to the liquid reservoir.

2. The system of claim 1, wherein the pump is configured to supply liquid from the liquid reservoir to the boiling chamber; and/or
wherein the pump is housed within a body of the heatsink.

3. The system of claim 1 or claim 2, wherein the pump is positioned outside the body of the heatsink.

4. The system of one of claims 1 to 3, further comprising a pressure sensor positioned within the boiling chamber.

5. The system of claim 4, further comprising a controller configured to communicate with the pump to adjust a volumetric flow rate and a pressure of the liquid being supplied to the boiling chamber.

6. The system of one of claims 1 to 5, further comprising an external heating system configured to heat the membrane; and/or
further comprising a valve positioned between the liquid reservoir and the boiling chamber, such that opening and closing of the valve regulates a fluid pressure within the boiling chamber; and/or
further comprising a check valve between the liquid reservoir and the vapor space, the check valve configured to prevent liquid from passing from the liquid reservoir to the vapor space.

7. The system of one of claims 1 to 6, wherein the boiling chamber, the vapor space, and the liquid reservoir form a closed loop.

8. The system of one of claims 1 to 7, further comprising a condensate trap positioned within the vapor space, the condensate trap configured to direct condensed liquid within the vapor space to the liquid reservoir.

9. The system of one of claims 1 to 8, wherein the heatsink is mountable to the external heat source such that a portion of the heatsink body surrounding the boiling chamber contacts the external heat source at a position directly above the external heat source.

10. A heatsink cooling system comprising:
a liquid reservoir in fluid communication with a boiling chamber;
a vapor space separated from the boiling chamber by a membrane; and
a pumping system configured to supply liquid from the liquid reservoir to the boiling chamber, such that upon the boiling chamber being heated by an external heat source, vapor passes through the membrane into the vapor space, condenses, and returns to the liquid reservoir to form a closed loop.

11. The system of claim 10, further comprising a condenser region positioned adjacent the vapor space.

12. The system of claim 11, wherein the condenser region includes a plurality of fins.

13. The system of one of claims 10 to 12, wherein the pumping system includes a piston-driven pump; and/or
wherein the reservoir and pump are positioned outside a body of the heatsink and are fluidly connected with the boiling chamber and vapor space; and/or
further comprising an external reservoir fluidly connected to the liquid reservoir.

14. A method of cooling a chip using a heatsink cooling system, the method comprising:
positioning a boiling chamber of the heatsink adjacent the chip such that the chip heats the boiling chamber;
modulating a valve to supply a liquid from a reservoir to the boiling chamber such that the liquid boils and evaporates through a membrane separating the boiling chamber from a vapor space; and
directing condensed vapor from the vapor space to the reservoir to form a closed loop.

15. The method of claim 14, wherein the directing includes catching liquid in a condensate trap and directing the liquid to the reservoir; and/or
further comprising supplying a liquid to the reservoir from an external reservoir positioned within a rack of a data center.
